# EUROPÄISCHE PATENTSCHRIFT

(11) **EP 4 190 135 B1**
(45) Veröffentlichungstag und Bekanntmachung des Hinweises auf die Patenterteilung: **11.09.2024**
(21) Anmeldenummer: 21749593.6
(22) Anmeldetag: 26.07.2021
(51) Int. Cl.: H05K 7/14

(54) **EXPLOSIONSGESICHERTES GEHÄUSE FÜR EIN LEISTUNGSELEKTRONISCHES GERÄT**
EXPLOSION PROOF HOUSING FOR A POWER ELECTRONICS DEVICE
BOÎTIER ANTIDÉFLAGRANT POUR UN APPAREIL ÉLECTRONIQUE DE PUISSANCE

(30) Priorität: 27.07.2020 DE 102020119779
(43) Veröffentlichungstag der Anmeldung: 07.06.2023
(73) Patentinhaber: SMA Solar Technology AG, 34266 Niestetal (DE)
(72) Erfinder: MUELLER, Steffen, 34134 Kassel (DE); TELLO, Waissi, 34127 Kassel (DE)
(86) Internationale Anmeldenummer: PCT/EP2021/070851
(87) Internationale Veröffentlichungsnummer: WO 2022/023264

(56) Entgegenhaltungen:
- CN-A- 104 835 929
- CN-U- 201 942 983
- CN-U- 202 666 663
- CN-U- 204 832 472
- CN-U- 205 212 201
- CN-U- 207 555 070
- DE-U1- 202014 100 486
- DE-U1- 202015 106 657
- DE-U1- 202018 103 164
- FR-A- 613 258
- GB-A- 391 829
- US-A- 1 269 064
- US-A- 3 638 364
- US-A1- 2019 128 358

## Beschreibung

Die Erfindung betrifft ein Gehäuse für ein leistungselektronisches Gerät. Eine Befestigung eines Deckels des Gehäuses erfolgt hierbei derart, dass der Deckel im Fall einer Explosion im Inneren des Gehäuses zuverlässig auf dem übrigen Gehäusekörper gehalten wird.

Bei leistungselektronischen Vorrichtungen, beispielsweise Wechselrichtern zur Umwandlung von als Gleichstrom bereitgestellter Eingangsleistung in eine als Wechselstrom bereitgestellte Ausgangsleistung, kann es im Inneren von Gehäusen dieser Vorrichtungen zu einer möglichen Explosion von Komponenten, beispielsweise Kondensatoren oder Leistungsschaltermodule kommen, deren möglicher Explosionsdruck mit der aufgrund der technologischen Weiterentwicklung kontinuierlich steigenden Leistungsdichte zunimmt. Da es derzeit noch unzureichende Sicherheitsvorschriften zur Auslegung von Gehäusen für solche Vorrichtungen gibt, wurde bereits von Vorfällen berichtet, in denen Personen, die sich in der Nähe der Vorrichtung befunden haben, durch herumfliegende Gehäuseteile verletzt wurden, die sich durch eine Explosion gelöst haben.

Daher existieren Lösungen, Gehäuse derart zu gestalten, dass sich auch bei einer Explosion keine Gehäuseteile lösen. Um nicht unnötig stabile und damit materialintensive Gehäuseformen herstellen zu müssen, erscheint es vorteilhaft, Gehäuse so zu gestalten, dass ein Deckel als erste Gehäusekomponente sich im Explosionsfall von einer Wanne als zweiter Gehäusekomponente unter Bildung eines Auslassspalts kontrolliert abzulösen vermag, damit der Explosionsdruck durch den Auslassspalt entweichen kann.

Hierzu wird in dem Dokument DE 20 2014 100 486 A1 vorgeschlagen, Deckel und Wanne über ein deformierbares Befestigungselement zu verbinden, das einen geschlossenen Ring aufweist, wobei das Befestigungselement auf gegenüberliegenden Abschnitten jeweils mit dem Deckel und dem Gehäuse verschraubt wird. Ein solches Befestigungselement beansprucht allerdings erheblichen Bauraum und eignet sich daher nur für ausgewählte Anwendungsfälle.

In der Schrift GB 391829 wird beispielsweise vorgeschlagen, eine Befestigungsschraube für einen Deckel auf einer Wanne eines Trennschaltergehäuses mit einer Unterlegscheibe mit Sollbruchstelle auszustatten, die im Explosionsfall bricht und so die Bildung eines Spaltes zum Druckabbau ermöglicht.

Für die Verwendung im Luft- und Straßenverkehr schlägt das Dokument US 2019/0128358 A1 eine Verschraubung von Bauteilen über verformbare Distanzstücke vor, die bei Überschreitung einer Grenzlast einen Energiebetrag durch plastische Verformung aufnehmen. Einen ähnlichen Vorschlag enthält die Schrift US 3638364 für die Verwendung bei Schneidvorrichtungen.

Darüber hinaus offenbart die Schrift CN 1043835929 B eine explosionsgeschützte Batteriebox mit Befestigungsschrauben für einen Deckel der Box, die mit Schraubenfedern hinterlegt sind, so dass sich im Explosionsfall vorübergehend ein Austrittsspalt bildet.

Für die Verbindung von Rohren offenbart die Schrift CN 207555070 U eine Verschraubung mittels einer vorgebogenen elastischen Tellerdichtung, die bei Überschreiten einer Grenzbelastung umschlägt und so eine dauerhafte Spaltbildung zwischen den verbundenen Rohren erlaubt.

Alternativ wird in der Schrift DE 20 2015 106 657 U1 vorgeschlagen, einen Gehäusekörper oder einen Gehäusedeckel an deren Befestigungspunkten mit einer Aussparung so zu umgeben, dass sich ein Spalt zwischen Gehäusekörper und Gehäusedeckel ausbildet, wenn ein Innendruck im Gehäuse einen vorgegebenen Grenzwert überschreitet. Auch eine solche Gehäusegestaltung ist auf ausgewählte Anwendungsfälle begrenzt und eignet sich insbesondere bei Gehäuseteilen, die aus Blech durch Kaltformung gebildet sind.

Häufig besteht aber auch der Wunsch, einen bestehenden Typ eines Gehäusedeckels mit geringstmöglichem Aufwand für die Neugestaltung und die Fertigung so abzuwandeln, dass ein vollständiges Ablösen des Gehäusedeckels im Falle einer Explosion im Gehäuseinneren mit einer vorgegebenen, auf den Deckel wirkenden Explosionslast vermieden wird.

Dieser Erfindung liegt daher die Aufgabe zugrunde, einen Gehäusedeckel aufzuzeigen, der kostengünstig und mit geringem Gestaltungsaufwand hergestellt werden kann, und der im Explosionsfall zuverlässig am Gehäuse befestigt bleibt.

Diese Aufgabe wird durch ein Gehäuse mit den Merkmalen des Anspruchs 1 gelöst. Bevorzugte Ausführungsformen sind in den abhängigen Ansprüchen angegeben.

In einem ersten Aspekt betrifft die Erfindung ein Gehäuse für ein leistungselektronisches Gerät. Das Gehäuse umfasst eine Wanne zur Aufnahme von leistungselektronischen Komponenten und einen Deckel zum Aufsetzen auf die Wanne, so dass ein geschlossenes Gehäuse gebildet wird. Der Deckel ist mit einer Mehrzahl von Fixierschrauben auf der Wanne fixiert. Es ist zumindest ein Öffnungselement vorgesehen, das durch eine der Fixierschrauben gebildet ist, die jeweils durch eine Hülse mit Deformationsstrukturen geführt ist, die zwischen Schraubenkopf der Fixierschraube und Gehäuse angeordnet ist, so dass eine Anpresskraft zwischen Deckel und Wanne vom Schraubenkopf über die Hülse ausgeübt wird. Die Hülse ist hinsichtlich Material, Materialstärke und Formgebung derart ausgeführt, dass der zur Fixierung des Deckels auf der Wanne ausgeübte Anpressdruck hierbei zu keiner wesentlichen Deformation der Hülse führt. Die Deformationsstrukturen der Hülse sind derart ausgebildet, dass unter Einwirken einer die Anpresskraft übersteigenden Explosionskraft, ausgelöst beispielsweise durch eine Explosion von leistungselektronischen Komponenten, wodurch sich ein Überdruck im Inneren des Gehäuses ausbildet, die Hülse in einer durch die Deformationsstrukturen definierten Weise derart komprimiert wird, dass zwischen Deckel und Wanne ein Spalt vorgegebener Breite gebildet wird.

In einer bevorzugten Ausführung sind die Schraubenköpfe der Fixierschrauben auf der dem Deckel gegenüberliegenden Seite der Wanne angeordnet. Bevorzugt greift die Fixierschraube mit dem Gewinde in ein Gegengewinde des Deckels ein. Das Gegengewinde kann als Blindgewinde ausgeführt sein, so dass die Verschraubung auf einer der Wanne abgewandten Seite des Deckels nicht sichtbar ist. Das Blindgewinde kann direkt in das Material des Deckels geschnitten sein, oder als Gewindehülse wannenseitig an dem Deckel, beispielsweise durch Einpressen, befestigt sein.

Durch die Bildung des Spalts kann der Überdruck aus dem Inneren des Gehäuses entweichen, wobei der Deckel an der Wanne fixiert bleibt. Durch die Kompression der Hülse wird im Moment der Wirkung der Explosionskraft die Verbindung zwischen Fixierschraube und Gegengewinde bereits vor dem Entweichen des explosionsbedingten Überdrucks entlastet, um der Gefahr entgegenzuwirken, dass sich Wanne und Deckel aufgrund eines Ausreißens der Fixierschraube aus dem Gegengewinde voneinander lösen. Die Deformationsstrukturen, die in die Hülse eingebracht sind, stellen eine gezielte Schwächung der mechanischen Stabilität der Hülse dar, so dass die Hülse eine ausreichende mechanische Stabilität aufweist, um die Anpresskraft im Rahmen einer ordnungsgemäßen Deckelmontage auf der Wanne ohne eine wesentliche Deformation der Hülse bereitzustellen. Unter Einwirkung der wesentlich höheren Explosionskraft jedoch erfolgt eine komprimierende Deformation der Hülse in einer durch die Gestaltung der Deformationsstrukturen bestimmten Weise, wobei die für die Deformation erforderlichen Kompressionskräfte durch die Gestaltung der Deformationsstrukturen einstellbar sind.

Erfindungsgemäß ist an dem Gehäuse mindestens ein zusätzliches Bremselement vorgesehen. Dieses zusätzliche Bremselement umfasst eine Schraube und eine weitere Hülse mit Deformationsstrukturen, wobei die Schraube durch die weitere Hülse geführt ist. Dabei ist die weitere Hülse zwischen dem Schraubenkopf der Schraube des Bremselements und dem Gehäuse derart angeordnet, dass die weitere Hülse in einer durch die Deformationsstrukturen definierten Weise erst dann komprimiert wird, wenn der Spalt zwischen Deckel und Wanne eine vorgegebene Mindestbreite erreicht.

Für ein Gehäuse eines leistungselektronischen Gerätes bestehend aus einer Gehäusewanne und einem Gehäusedeckel sind zwei Hauptfunktionen zu realisieren. Zum einen muss eine ausreichende Dichtigkeit gewährleistet sein und zum anderen muss im Schadensfall ein Explosionsschutz sichergestellt sein. Für die Dichtigkeit ist daher ein möglichst hoher Anpressdruck des Deckels auf der Wanne vorteilhaft, der durch die Fixierschrauben bereitgestellt wird. Für den Explosionsschutz hingegen ist es vorteilhaft, dass die Öffnungselemente, die durch die Fixierschrauben mit den deformierbaren Hülsen gebildet sind, zu einem möglichst frühen Zeitpunkt, also bereits bei einem möglichst geringen Explosionsdruck im Inneren des Gehäuses, öffnen und einen Spalt freigeben. Je nach Auslegung des leistungselektronischen Gerätes, können jedoch auch in kurzer Zeit derart hohe Explosionsdrücke entstehen, dass das Energieabsorptionsvermögen der Hülsen der Öffnungselemente durch Kompression nicht mehr ausreicht, um genügend Explosionsenergie aufzunehmen, bevor die Zerstörungsschwelle erreicht ist und die Fixierschrauben beispielsweise aus den Gewinden gerissen werden. Eine vergrößerte Dimensionierung der Öffnungshülsen ist technisch jedoch oftmals nicht möglich, etwa wegen des geringen Bauraums. Insbesondere darf die Hülsenlänge nicht beliebig vergrößert werden. Dabei entstünde zwar ein größerer Kompressionsweg der Hülsen und damit einhergehend eine größere Energieabsorptionsfähigkeit, jedoch kann dann der Öffnungsspalt zu groß werden, so dass beispielsweise zerstörte, aber noch immer stromführende Teile freiliegen.

Durch das Bereitstellen von zusätzlichen Bremselementen wird die Brems- und Absorptionsfunktion im Wesentlichen von der Anpress- und Öffnungsfunktion getrennt. Auch in dieser vorteilhaften Ausführungsform wird der Anpressdruck durch die Fixierschrauben der Öffnungselemente bereitgestellt. Ebenso ermöglichen die Hülsen der Öffnungselemente eine Spaltbildung zwischen Deckel und Wanne. Erst wenn sich bereits ein Spalt gebildet hat, setzt die Energieabsorptionswirkung der zusätzlichen Bremselemente ein, so dass das Gehäuse deutlich größeren Explosionsdrücken standhalten kann, ohne die Zerstörschwelle zu erreichen. Die Schrauben und Hülsen der Bremselemente sind dabei derart gestaltet und angeordnet, dass die zusätzliche Absorptionsfähigkeit erst ab einer vorgegebenen Mindestbreite des Spaltes einsetzt. So kann je nach Bedarf eine schnelle Spaltbildung mit einer hohen Energieaufnahme kombiniert werden.

In einer bevorzugten Ausführung sind die Schraubenköpfe der zusätzlichen Bremselemente ebenso wie die Fixierschrauben der Öffnungselemente auf der dem Deckel gegenüberliegenden Seite der Wanne angeordnet und greifen mit ihrem Gewinde bevorzugt in gleichartige Gegengewinde des Deckels wie die Fixierschrauben ein. Dadurch wird insbesondere eine Flexibilität des Explosionsschutzes gewährleistet und die Möglichkeit eröffnet, zusätzliche Bremselemente in Anzahl und Form an die Anforderungen des Gehäuses anzupassen. Insbesondere ermöglicht die Anordnung von zusätzlichen Bremselementen in bereits bestehende Gewinde des Gehäuses eine Nachrüstung von optimiertem Explosionsschutz in Bestandsgeräte.

In einer weiter bevorzugten Ausführung sind der Schraubenkopf und die Hülse des zusätzlichen Bremselements beabstandet voneinander angeordnet. Dieser Abstand ist in Abhängigkeit von der vorgegebenen Mindestbreite gewählt. Die zusätzlichen Bremselemente steuern ihre zusätzliche Energieabsorptionsfähigkeit somit erst bei, wenn sich der Spalt entsprechend der Mindestbreite gebildet hat. Der Schraubenkopf berührt dann den Anfangsbereich der weiteren Hülse und eine Kraftübertragung von Schraubenkopf auf die Hülse beginnt. Mit weiterer Öffnung des Spalts, durch den noch nicht abgebauten inneren Explosionsdruck, wird die Hülse komprimiert und nimmt zusätzliche Energie durch kontrollierte mechanische Deformation auf.

Weiterhin ist es denkbar, dass die Schraube des zusätzlichen Bremselements ein sich über den gesamten Schraubenschaft erstreckendes Gewinde aufweist. Bei zunehmender Kompression der Hülse ergibt sich bei dieser Ausführung eine erhöhte Absorptionswirkung durch Verzahnung von Hülse und Gewinde. Insbesondere ist es bevorzugt, dass die Hülse des zusätzlichen Bremselements einen annähernd linearen Kraftverlauf aufweist. Das bedeutet im Detail, dass die Hülse des zusätzlichen Bremselements einer zunehmenden Kompression um einen Versatz d, also bei zunehmender Spaltöffnung, eine größer werdende Kraft F entgegenbringt. Das kann dadurch gewährleistet sein, dass die Hülse unterschiedlich nachgiebige Bereiche aufweist, die mit unterschiedlicher Kraft komprimierbar sind.

In einer bevorzugten Ausführung der Erfindung sind die Fixierschrauben und, optional, die Schrauben der zusätzlichen Bremselemente jeweils in einem Führungskanal der Wanne angeordnet. Hierdurch können zum einen die Schraubenköpfe beim Verschrauben geführt und zugunsten eines einheitlichen Erscheinungsbilds des Gehäuses versteckt werden. Zum anderen kann der Führungskanal gezielt genutzt werden, um den Verlauf der während der Kompression der Hülse durch diese bereitgestellten Gegenkräfte der Deformation zu gestalten. Dieses kann dadurch bewerkstelligt werden, dass der Querschnitt des Kanals im Bereich der Hülse derart gewählt wird, dass die deformierte Hülse im Verlauf der Kompression die Seitenwände des Führungskanals berührt. Nach Berührung der Seitenwände kann die Hülse eine erhöhte Gegenkraft gegen eine weitere Deformation bereitstellen, wodurch die vollständige Kompression der Hülse hinausgezögert wird. In der Folge kann die Hülse so höhere Explosionskräfte erfolgreich aufnehmen, ohne dass es zu einem Ausreißen der Schraube aus dem Gegengewinde kommt.

In einer weiteren bevorzugten Ausführungsform ist die Hülse derart vorgeformt, dass sie beim Aufstecken auf einen Schaft der Schraube verliersicher gehalten wird. Dies kann erreicht werden, indem die Hülse auf der dem Schraubenkopf zugewandten Seite mit einem zum Hülseninneren gerichteten Kragen versehen ist, der in einen verjüngten Bereich des Schraubenschafts eingreift. Es ist ebenfalls denkbar, die Hülse derart vorzuformen, dass sie einen Bereich mit einem verjüngten Innendurchmesser aufweist, in dem sie nach Aufstecken auf die Schraube federnd gegen das Gewinde drückt.

Alternativ oder ergänzend kann die Schraube ein Zentrierelement aufweisen, das derart angeordnet ist, dass die Hülse in einer relativ zur Schraube zentrierten Position gegen den Schraubkopf gepresst wird. Das Zentrierelement kann als konisch geformter Aufsatz direkt am Kopf der jeweiligen Schraube angeordnet und beispielsweise aus Kunststoff gebildet sein. Hierdurch wird der Kompressionsvorgang besser reproduzierbar, weil ein Verkanten der Hülse vermieden wird. Ein solches Zentrierelement kann sowohl bei den Fixierschrauben als auch bei mindestens einer der Schrauben der zusätzlichen Bremselemente vorgesehen sein.

Alternativ kann das Gehäuse zum Fixieren der Hülse an der Wanne vor dem Verschrauben ausgeführt sein. Hierzu kann die Wanne entsprechende Haltestrukturen für die Hülse aufweisen. Ebenfalls denkbar ist es, die Hülse als Einpresshülse auszuführen, die vor dem Verschrauben des Gehäuses in eine geeignete Ausnehmung der Wanne eingepresst und dadurch fixiert wird.

Weiterhin ist es denkbar, dass die Wanne eine Formgebungsstruktur aufweist, auf die die Hülse aufgesetzt ist, und die gestaltet ist, unter Einwirkung der Explosionskraft die Deformation der Hülse zu bestimmen. So kann die Formgebungsstruktur beispielsweise einen konischen Bereich aufweisen, der unter Einwirkung der Explosionskraft zu einer radialen Spreizung oder Stauchung der Hülse führt. Auf diese Weise kann die erforderliche Kraft, ab der es zu einer Deformation der Hülse kommt, auf einen geeigneten Wert reduziert werden. Derart wirkende Formgebungsstrukturen können alternativ oder ergänzend auch am Schraubenkopf angeordnet sein.

In einer vorteilhaften Variante können die Deformationsstrukturen als Schlitze ausgebildet sein. Die Schlitze können longitudinal in einem zentralen Bereich der Hülse verlaufen, so dass zwischen den Schlitzen Stege verbleiben, die sich unter Einwirkung der Explosionskraft nach außen verformen. Bevorzugt werden mindestens drei Schlitze vorgesehen, so dass mindestens drei Stege entstehen. Es ist aber auch denkbar, mehr als drei Schlitze vorzusehen. Ebenfalls denkbar ist es, anstelle longitudinal verlaufender Schlitze solche vorzusehen, die einen gewinkelten Verlauf aufweisen. Durch eine solche Gestaltung entsteht eine Torsionskomponente bei der Kompression der Hülse.

Anstelle von Schlitzen können die Deformationsstrukturen auch eine andere Formgebung und Anordnung zueinander aufweisen, die zu einer gewünschten Kompression der Hülse führen. Beispielsweise ist es denkbar, eine Vielzahl von Löchern in der Hülse vorzusehen. Eine Hülse mit über deren Verlauf unterschiedlicher Nachgiebigkeit, könnte dann derart gestaltet sein, dass in unterschiedlichen Bereichen der Hülse unterschiedlich große Löcher oder unterschiedlich große Lochabstände vorgesehen sind und somit zwischen den Löchern mehr oder weniger Material stehen bleibt, das komprimiert werden muss. Die Deformationsstrukturen können unabhängig von deren Anordnung oder Form durch Entfernen von Hülsenmaterial hergestellt sein. Ein Entfernen zur Bildung der Deformationsstrukturen kann durch Laserschneiden, aber auch durch andere vorbekannte Verfahren durchgeführt werden.

Es ist aber auch denkbar, die Deformationsstrukturen als Prägestrukturen auszuführen. Durch einen geeigneten Prägestempel werden die Deformationsstrukturen dann eingeprägt, ohne dass Hülsenmaterial entfernt wird.

In einer weiteren vorteilhaften Ausführung sind zur Fixierung und Sicherung des Deckels auf der Wanne in abwechselnder Reihenfolge Öffnungselemente mit Fixierschrauben und Hülsen und Bremselemente mit Schrauben und weiteren Hülsen vorgesehen. Dabei ist es besonders vorteilhaft, dass bei einem Gehäuse mit einer rechteckigen Grundform, die Öffnungselemente mittig an den Längsseiten und die zusätzlichen Bremselemente in den Eckbereichen angeordnet sind. Es hat sich herausgestellt, dass eine derartige Anordnung, angesichts einer lokalen Ungleichverteilung des inneren Explosionsdrucks, insbesondere zu Beginn einer Explosion, wenn in der Regel nur einzelne leistungselektronische Komponenten explodieren, eine ausreichende Verteilung der Explosionskraft ermöglicht. Insbesondere in Verbindung mit in unterschiedlichen Bereichen unterschiedlich nachgiebigen Hülsen, kann einer asymmetrischen Spaltbildung entgegengewirkt werden.

Im Folgenden wird die Erfindung mithilfe von Figuren dargestellt, von denen
- Fig. 1a: einen ersten Querschnitt eines Öffnungselements eines erfindungsgemäßen Gehäuses im Bereich einer Verschraubung,
- Fig. 1b: einen ersten Querschnitt eines Bremselements eines erfindungsgemäßen Gehäuses im Bereich einer Verschraubung,
- Fig. 2a: einen zweiten Querschnitt eines Öffnungselements eines erfindungsgemäßen Gehäuses im Bereich einer Verschraubung nach einer Explosion im Gehäuseinneren,
- Fig. 2b: einen zweiten Querschnitt eines Bremselements eines erfindungsgemäßen Gehäuses im Bereich einer Verschraubung nach einer Explosion im Gehäuseinneren,
- Fig. 3: eine erste Ansicht auf einen Verschraubungsbereich eines erfindungsgemäßen Gehäuses,
- Fig. 4: eine zweite Ansicht auf einen Verschraubungsbereich eines erfindungsgemäßen Gehäuses im Bereich einer Verschraubung nach einer Explosion im Gehäuseinneren,
- Fig. 5: drei Ausführungen einer deformierbaren Hülse zur Verwendung einer Gehäuseverschraubung, sowie
- Fig. 6: ein schematischer Verlauf einer Kraftausbildung bei einer Deformation einer Hülse des Öffnungselementes und einer Hülse eines Bremselements während einer Explosion im Gehäuseinneren zeigen.

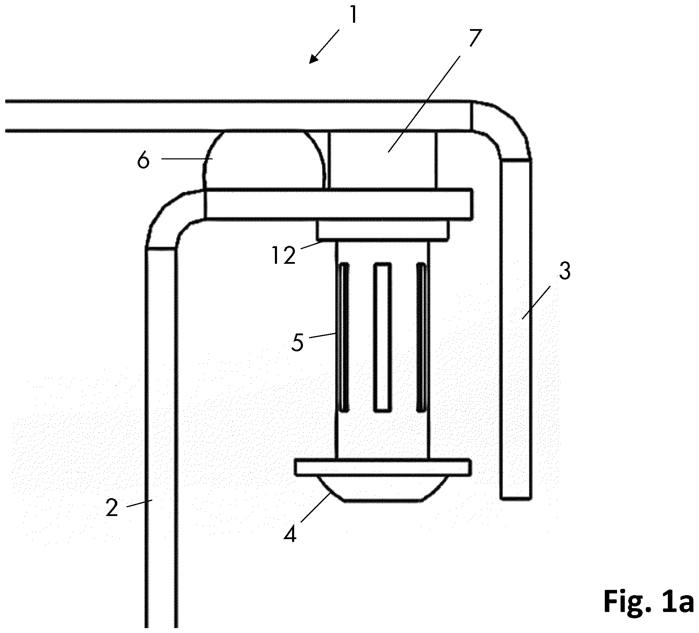

Fig. 1a zeigt einen Querschnitt durch ein Öffnungselement eines Gehäuses 1 eines leistungselektronischen Geräts, beispielsweise eines Wechselrichters, im Bereich einer Verschraubung. Ein Deckel 3 des Gehäuses wird mittels einer Fixierschraube 4 auf einer Wanne 2 des Gehäuses fixiert und gegen eine zwischen Deckel 3 und Wanne 2 angeordnete Dichtung 6 gedrückt. Die Anpresskraft wird mittels der Fixierschraube 4 ausgeübt, die in ein Gewinde 7 des Deckels 3 eingreift. Zwischen einem Kopf der Fixierschraube 4 und der Wanne 2 ist eine Hülse 5 angeordnet, die vor dem Verschrauben auf das Schraubengewinde gesteckt wurde, so dass die Anpresskraft vom Schraubenkopf der Fixierschraube 4 über die Hülse 5 auf die Wanne 2 ausgeübt wird. In diesem Zustand behält die Hülse 5 weitgehend ihre Ausgangsform vor dem Verschrauben bei. Dabei weist die Hülse 5 auf der der Wanne 2 zugewandten Seite einen Kragen 12 auf. Das Gehäuse 1 weist eine einzelne oder eine Mehrzahl von solchen als Öffnungselement dienenden Verschraubungen auf, beispielsweise jeweils an den Gehäuseecken oder mittig an den Längsseiten.

In einer Ausführung dient der Kragen 12 der Halterung der Hülse 5 an der Wanne 2, zum Beispiel durch Einpressen in eine Aufnahme in der Wanne 2, und die Fixierschraube 4 wird durch die an der Wanne 2 gehaltene Hülse 5 eingeführt und mit dem Gewinde 7 des Deckels 2 verschraubt.

In dem in Fig. 1a gezeigten Zustand ist das Innere des Gehäuses 1 gegenüber der Außenumgebung vollständig abgedichtet, und das leistungselektronische Gerät ist betriebsbereit.

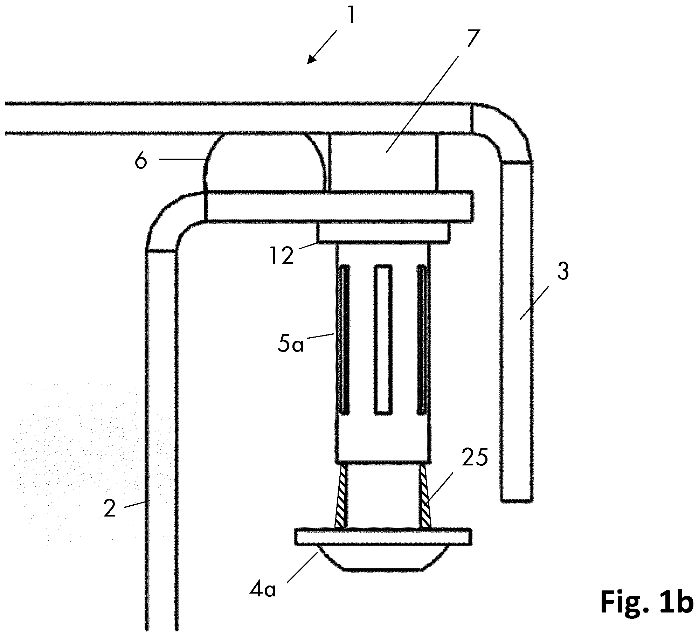

Fig. 1b zeigt einen Querschnitt durch ein Gehäuse 1 eines leistungselektronischen Geräts im Bereich einer Verschraubung, in der ein zusätzliches Bremselement angeordnet ist. Das Gehäuse befindet sich dabei in dem gleichen abgedichteten Zustand wie in Fig. 1a. Eine Schraube 4a des Bremselements greift durch eine Öffnung der Wanne 2 in ein Gewinde 7 des Deckels 3 des Gehäuses 1 ein. Die Fixierung des Deckels 3 auf der Wanne 2 und die Abdichtung, durch die zwischen Deckel 3 und Wanne 2 angeordnete Dichtung 6, wird jedoch nicht über die Schraube 4a des Bremselements bereitgestellt, sondern durch eine oder mehrere Fixierschrauben 4 an anderen Verschraubungen des Deckels, wie in Fig. 1a beschrieben.

Zwischen einem Kopf der Schraube 4a und der Wanne 2 ist eine weitere Hülse 5a des Bremselements angeordnet, die vor dem Verschrauben auf das Schraubengewinde gesteckt wurde. Der Schraubenkopf der Schraube 4a und die Hülse 5a sind beabstandet voneinander angeordnet, so dass keine Anpresskraft vom Schraubenkopf der Schraube 4a über die Hülse 5a auf die Wanne 2 ausgeübt wird. Der Abstand zwischen dem Schraubenkopf der Schraube 4a und der Hülse 5a bestimmt in dieser Ausführung die Mindestbreite eines Spalts 11, der sich im Explosionsfall geöffnet haben muss, bevor die Energieabsorption des Bremselements durch die Kompression der Hülse 5a einsetzt. Am Schraubenkopf ist ein Zentrierelement 25 angeordnet, dessen Funktion es ist, die Hülse 5a im Rahmen der Kompression in eine relativ zur Schraube 4a zentrierten Position zu bringen, so dass ein Verkanten der Hülse ausgeschlossen wird. Hierdurch wird der Kompressionsvorgang besser reproduzierbar. Ein solches Fixierelement kann auch am Kopf der Schraube 4 aus Fig. 1a angeordnet sein.

Die Hülse 5a weist ebenfalls auf der der Wanne zugewandten Seite einen Kragen 12 auf. In der gezeigten Ausführung dient der Kragen 12 der Halterung der Hülse 5a an der Wanne 2, ebenso wie bei der Hülse 5 des Öffnungselements, zum Beispiel durch Einpressen in eine Aufnahme in der Wanne 2. Das Gehäuse 1 kann eine Mehrzahl von solchen als Bremselemente dienenden Verschraubungen aufweisen.

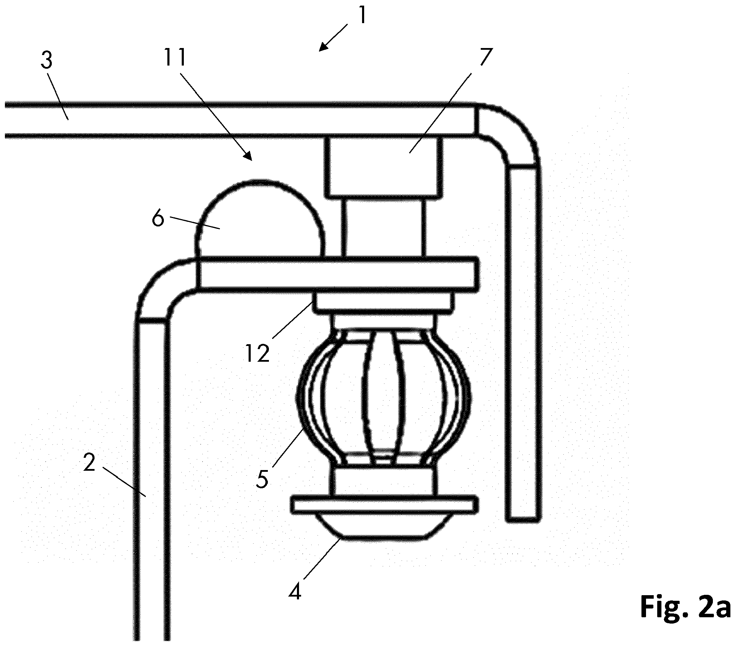

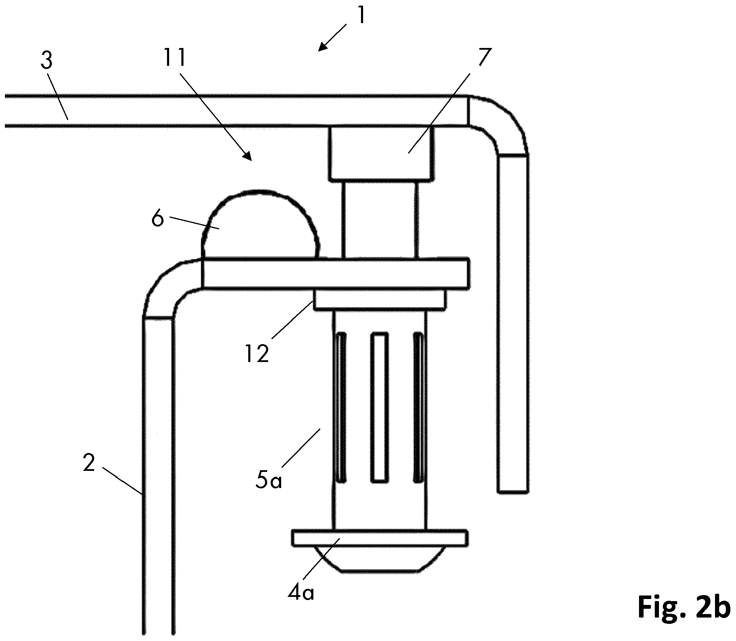

Kommt es, wie in Fig. 2a und 2b dargestellt, nun zu einer Explosion im Gehäuseinneren, beispielsweise durch eine Überlastung dort angeordneter leistungselektronischer Komponenten, entwickelt sich ein Überdruck im Gehäuseinneren, der sich auf die Fixierschrauben 4 und die zwischen Wanne 2 und Schraubenkopf angeordneten Hülsen 5 der Öffnungselemente überträgt. Hierdurch wird eine derart hohe Kraft auf die Hülsen 5 ausgeübt, dass diese durch Kompression deformiert werden und teilweise kollabieren, wodurch sich der Abstand zwischen Schraubenkopf und Wanne 2 verringert. Hierdurch wird ein Spalt 11 zwischen Wanne 2 und Deckel 3 gebildet, durch den der Überdruck aus dem Gehäuseinneren entweichen kann. Dies führt umgehend zu einem Abbau der auf die Fixierschrauben 4 wirkenden Kraft, so dass die Hülsen 5 nur teilweise kollabieren und die Verbindung zwischen Fixierschraube 4 und Deckel 3 erhalten bleibt und der Deckel 3 weiterhin auf der Wanne 2 gehalten wird. Wenn sich der Spalt 11 um die durch den Abstand zwischen Schraubenkopf der Schraube 4a und Hülse 5a des Bremselements definierten Mindestbreite geöffnet hat, hat der Schraubenkopf der Schraube 4a den Abstand zu der Hülse 5a überwunden und beginnt zusätzlich eine Kraft auf die Hülsen 5a der Bremselemente zu übertragen. Die Hülsen 5a werden nun ebenfalls komprimiert, was zu einem verbesserten Abbau der auf die Fixierschrauben 4 wirkenden Kraft führt. Somit verbessert sich die Fähigkeit des Gehäuses auch höheren Explosionsdrücken standzuhalten.

Die Breite des sich bildenden Spalts 11 kann durch die Gestaltung der Hülsen 5 und 5a so vorgegeben werden, dass ein Hineingreifen in das Gehäuseinnere auch nach der Explosion nicht möglich ist. Dies führt zu einer Erhöhung der Gerätesicherheit, da auch nach einer Explosion im Inneren des Gehäuses 1 gefährliche Spannungen anliegen können, so dass ein Berührschutz sichergestellt werden muss. Die Gestaltung der Hülsen 5 und 5a der Öffnungselemente und der Bremselemente kann die Anzahl, die Abmessungen, die Materialwahl und die Formgebung der Hülsen 5, 5a betreffen. Die Formgebung kann hierbei insbesondere auch ein Vorsehen von Deformationsstrukturen an der Hülse umfassen. Beispielsweise ist es denkbar, Löcher oder Schlitze mittels subtraktiver Methoden vorzusehen, oder durch Prägen die lokale Dicke der Hülsen zu variieren. Die Deformationsstrukturen dienen dazu, eine Schwellkraft zu definieren, ab der die Hülse unter Kompressionskraft kollabiert, und die Verformung der Hülse beim Kollabieren zu beeinflussen. Bevorzugt liegt die Schwellkraft um mindestens 20% höher, in einer vorteilhaften Ausführung um mindestens 50% als die während des Verschraubens des Gehäuses auf die Hülse wirkende Maximalkraft, so dass das Kollabieren der Hülse unter Anwendung des maximal zulässigen Drehmoments auf die Schrauben wirksam vermieden wird.

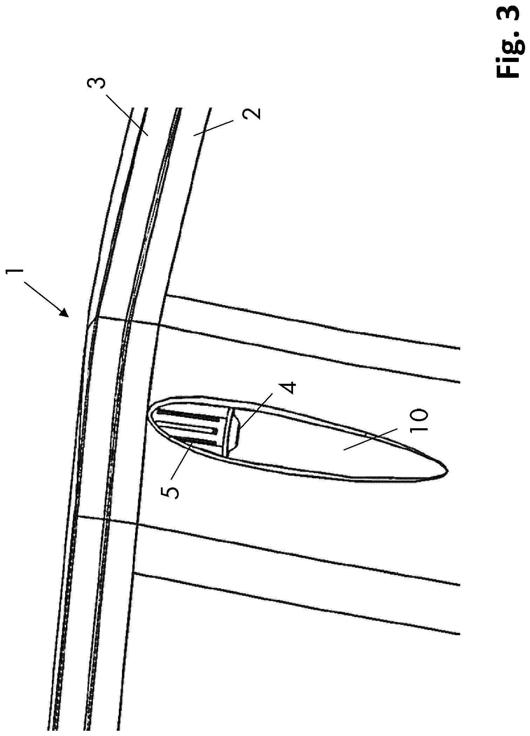

In Fig. 3 ist eine erste Ansicht auf einen Verschraubungsbereich eines Gehäuses 1 in einer vorteilhaften Ausführung gezeigt. Hier ist die Fixierschraube 4 in einem Führungskanal 10 angeordnet, der die Fixierschraube 4 optisch verkleiden kann und für eine laterale Führung der Fixierschraube 4, insbesondere des Schraubenkopfs sorgt. Auch die Schrauben 4a der Bremselemente sind vorteilhaft in einem derartigen Führungskanal 10 angeordnet. Hierdurch kann einem Verkanten der Verschraubung sowohl beim Verschrauben selbst als auch im Explosionsfall entgegengewirkt werden. In Fig. 3 ist der Führungskanal 10 in einer Schnittansicht gezeigt, wobei nicht ausgeschlossen ist, dass der Führungskanal 10 in der gezeigten angeschnittenen Form ausgeführt ist.

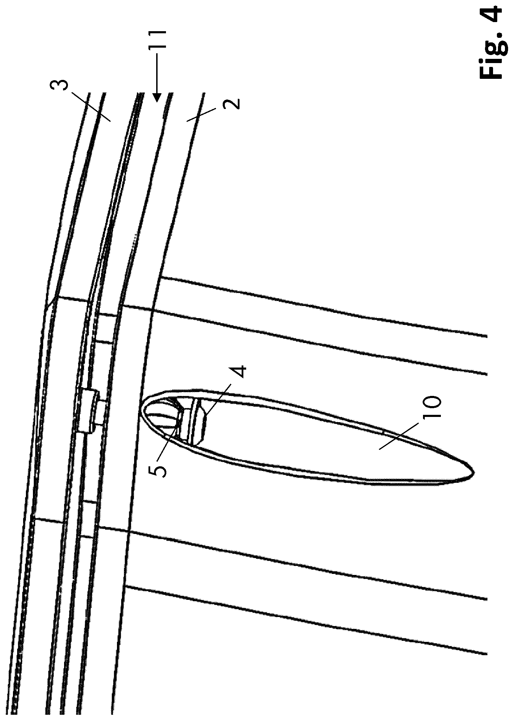

Wie in Fig. 4 gezeigt, bildet sich im Explosionsfall durch die Deformation der Hülse 5 des Öffnungselements ein Spalt 11, aus dem der Explosionsdruck aus dem Gehäuse 1 entweichen kann. Hierbei kann die Hülse 5 soweit kollabieren, dass sie die Innenwände des Führungskanals 10 berührt. Hierdurch wird die Gegenkraft der Hülse 5 gegen eine weitere Deformation gesteigert, so dass die Verbindung zwischen Fixierschraube 4 und Deckel 3 bis zu höheren Explosionskräften erhalten bleibt als ohne eine solche Berührung.

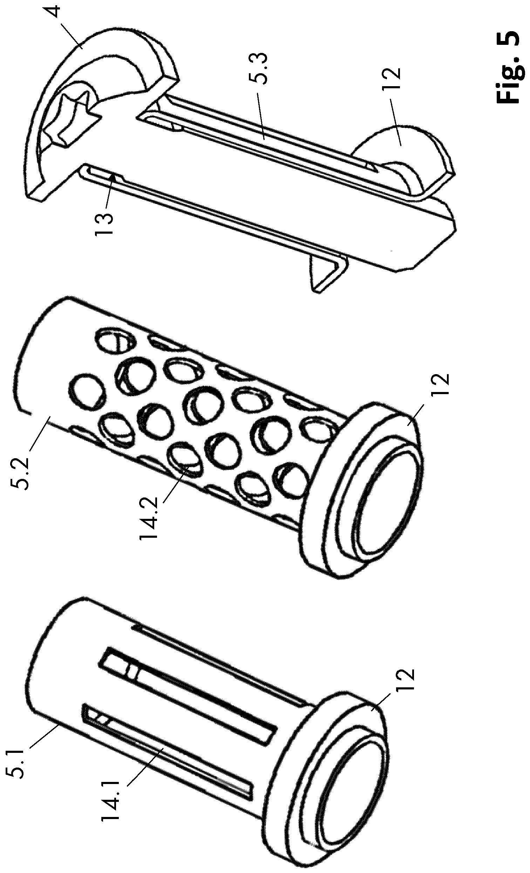

In Fig. 5 sind einige beispielhafte Ausführungen von Hülsen 5.1 bis 5.3 gezeigt, wie sie im Rahmen der Erfindung verwendet werden können. In einer ersten Ausführung weist die Hülse 5.1 Deformationsstrukturen 14.1 in Form von einer Mehrzahl an Schlitzen auf, zwischen denen Stege verbleiben. Beim Kollabieren der Hülse 5 werden die Stege in radialer Richtung nach außen gebogen.

In einer zweiten Ausführung weist die Hülse 5.2 eine Deformationsstruktur in Form einer Verteilung von Löchern über die Hülsenfläche auf. Zwischen den Löchern verbleibt ein Netzwerk von Stegen. Das Netzwerk wird unter Einfluss der Explosionskraft komprimiert. Insbesondere eine Ausführung mit einer Lochverteilung kann für die Hülsen 5a vorteilhaft dahingehend variiert sein, dass sich unterschiedlich nachgiebige Bereiche der Hülse 5a ergeben, die eine Kompression bei unterschiedlicher Krafteinwirkung ermöglichen. Insbesondere kann eine bei zunehmender Kompression der Hülse zunehmende Gegenkraft der Hülse realisiert sein, indem über den Verlauf der Hülse Löcher mit unterschiedlichen, insbesondere kleiner werdenden Durchmessern vorgesehen sind, so dass bei größeren Löchern schmalere Stege zwischen den Löchern angeordnet sind, die bei geringerer Krafteinwirkung verformbar sind und bei kleinen Löchern breitere Stege zwischen den Löchern angeordnet sind, die im Vergleich bei höherer Krafteinwirkung verformbar sind.

Unterschiedliche Komprimierungseigenschaften sind auch durch eine Kombination von verschiedenartigen Deformationsstrukturen realisierbar.

In einer dritten Ausführung ist eine verliersichere Anordnung einer Hülse 5.3 auf einer Fixierschraube 4 im Querschnitt gezeigt. Eine nach innen gerichtete Kröpfung der Hülse greift in eine Verjüngung 13 des Schraubenschafts ein, so dass die Hülse am Schaft verliersicher gehalten wird. Eine solche Anordnung führt zu einer vereinfachten, zuverlässigeren Montage des Gehäuses 1. Die Verliersicherheit kann auch auf andere Weise durch eine geeignete Formgebung von Hülse 5, 5a und/oder Fixier-/Schraube 4, 4a erreicht werden.

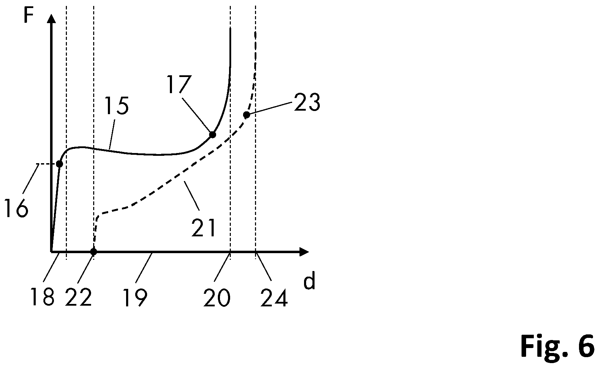

Fig. 6 zeigt einen Verlauf 15 einer Kraft F, die eine in einem Öffnungselement eines erfindungsgemäßen Gehäuses verwendete Hülse 5 einer Kompression um einen Versatz d entgegenbringt. In einem Fixierbereich 18, der beim Verschrauben des Gehäuses mit einer Fixierschraube 4 eingehalten wird, deformiert sich die Hülse 5 nicht oder nur um einen unerheblichen Versatz. Das bei der Montage verwendete Drehmoment der Fixierschraube 4 führt zu einer Kraft F, die einem Ausgangspunkt 16 auf dem Verlauf 15 entspricht. Beim Einwirken einer Explosionskraft auf die Hülse 5, die die Kraft F im Ausgangspunkt 16 erheblich überschreitet, wird die Hülse 5 in den Deformationsbereich 19 überführt, die Hülse 5 kollabiert und es bildet sich ein Versatz d unter gleichzeitiger Bildung eines Spalts 11 zwischen Deckel 3 und Wanne 2 des Gehäuses 1 aus. Durch den Spalt 11 kann der Überdruck der Explosion entweichen, wodurch die Explosionskraft umgehend abgebaut wird, so dass die Hülse 5 bis zu einem Endpunkt 17 auf dem Kraftverlauf 15 verschoben wird. Der dem Endpunkt 17 entsprechende Versatz d ist hierbei geringer als ein einem vollständigen Kollabieren 20 entsprechende Versatz d, der das Ende des Deformationsbereichs 19 definiert. Am Ende des Deformationsbereichs 19 steigt die zugehörige Kraft F steil an, so dass die Gefahr besteht, dass die Fixierschraube 4 aus dem Gewinde des Deckels 3 herausgerissen wird und sich der Deckel 3 von der Wanne 2 löst. Die Hülse 5 wird durch die vorstehend beschriebene Gestaltung bevorzugt so ausgelegt, dass auch bei der maximalen zu berücksichtigenden Explosionskraft der Endpunkt 17 einen ausreichenden Abstand von diesem Ende des Deformationsbereichs 19 liegt, also die Hülse 5 nicht vollständig kollabiert und so das Gewinde 7 entlastet wird, damit die Fixierschraube 4 nicht aus diesem ausreißen kann. Eine solche Gestaltung kann mittels Berechnungen, beispielsweise mit Finite-Elemente-Methoden, ausgelegt werden, wenn der Druckverlauf, zum Beispiel aus Vorversuchen, bekannt ist. Alternativ oder ergänzend kann eine Gestaltung der Hülse 5 durch Reihenexperimente mit unterschiedlicher Explosionskraft ermittelt beziehungsweise optimiert werden.

Im Falle, dass die zu berücksichtigende Explosionskraft nicht durch die vorbeschriebene Funktionsweise bis zu einem unkritischen Niveau abgebaut werden kann, ist die Verwendung von zusätzlichen Bremselementen vorteilhaft. Ein Verlauf 21 einer Kraft F, die eine in einem Bremselement eines erfindungsgemäßen Gehäuses verwendete Hülse 5a einer Kompression um einen Versatz d entgegenbringt, ist in Fig. 6 ebenfalls dargestellt (gestrichelter Verlauf). Erfindungsgemäß setzt eine Kompression der Hülse 5a erst dann ein, wenn sich der Spalt 11 bereits um eine Mindestbreite 22 geöffnet hat. Die Hülse 5a wird ebenfalls in ihren Deformationsbereich 19 überführt. Der Kraftverlauf 21 ist bei zunehmender Spaltöffnung vorteilhaft linear in dem Sinne, dass bei fortschreitender Kompression der Hülse 5a um einen weiteren Versatz d, eine erhöhte Gegenkraft aufgebracht wird. Das kann durch eine vorstehend beschriebene vorteilhafte Gestaltung der Deformationsstrukturen der Hülse realisiert sein. Dabei sollte auch bei der maximalen zu berücksichtigenden Explosionskraft der Endpunkt 23 des Deformationsbereichs 19 so gewählt sein, dass der dem Endpunkt 23 entsprechende Versatz d geringer ist, als ein einem vollständigen Kollabieren 24 entsprechende Versatz d, bei dem die zugehörige Kraft F steil ansteigt. Für die gesamte Gegenkraft des Deckels 3 summieren sich die Gegenkräfte der Hülsen 5 und 5a, so dass das Gehäuse 1 höheren Explosionskräften standhalten kann, beziehungsweise der durch Explosion von Komponenten erzeugte Überdruck besser abgebaut werden kann.

### Bezugszeichenliste

- 1: Gehäuse
- 2: Wanne
- 3: Deckel
- 4: Fixierschraube
- 4a: Schraube des Bremselements
- 5, 5.n: Hülse
- 5a: Weitere Hülse des Bremselements
- 6: Dichtung
- 7: Gewinde
- 10: Führungskanal
- 11: Spalt
- 12: Kragen
- 13: Verjüngung
- 14. n: Deformationsstruktur
- 15: Kraftverlauf der Hülse 5
- 16: Ausgangspunkt
- 17: Endpunkt
- 18: Fixierbereich
- 19: Deformationsbereich
- 20: Vollständiges Kollabieren Hülse 5
- 21: Kraftverlauf der Hülse 5a
- 22: Startpunkt/Mindestspaltbreite
- 23: Endpunkt
- 24: Vollständiges Kollabieren Hülse 5a
- 25: Zentrierelement

## Patentansprüche

1. Gehäuse (1) für ein leistungselektronisches Gerät, umfassend,
- eine Wanne (2) zur Aufnahme von leistungselektronischen Komponenten;
- einen Deckel (3) zum Aufsetzen auf die Wanne (2), so dass ein geschlossenes Gehäuse (1) gebildet wird
wobei der Deckel (3) mit einer Mehrzahl von Fixierschrauben (4) auf der Wanne (2) fixiert ist,
wobei mindestens ein Öffnungselement vorgesehen ist, wobei das Öffnungselement gebildet ist durch eine Fixierschraube der Mehrzahl von Fixierschrauben (4), die jeweils durch eine Öffnungshülse (5) mit Deformationsstrukturen (14.n) geführt ist, die zwischen Schraubenkopf der Fixierschraube (4) und Gehäuse (1) angeordnet ist, so dass eine Anpresskraft zwischen Deckel (3) und Wanne (2) vom Schraubenkopf der Fixierschraube (4) über die Öffnungshülse (5) ausgeübt wird,
wobei die Deformationsstrukturen (14.n) derart ausgebildet sind, dass unter Einwirken einer die Anpresskraft übersteigenden Explosionskraft die Öffnungshülse (5) in einer durch die Deformationsstrukturen (14.n) definierten Weise derart komprimiert wird, dass zwischen Deckel (3) und Wanne (2) ein Spalt (11) vorgegebener Breite gebildet wird, **dadurch gekennzeichnet, dass**
mindestens ein zusätzliches Bremselement vorgesehen ist,
wobei das mindestens eine zusätzliche Bremselement eine Schraube (4a) und eine weitere Hülse (5a) mit Deformationsstrukturen (14.n) umfasst, wobei die Schraube (4a) durch die weitere Hülse (5a) geführt ist,
wobei die weitere Hülse (5a) zwischen Schraubenkopf der Schraube (4a) und Gehäuse (1) derart angeordnet ist, dass die weitere Hülse (5a) in einer durch die Deformationsstrukturen (14.n) definierten Weise erst ab einer vorgegebenen Mindestbreite des Spaltes (11) komprimierbar ist.

2. Gehäuse (1) nach Anspruch 1, wobei der Schraubenkopf (4a) und die Hülse (5a) des zusätzlichen Bremselements beabstandet voneinander angeordnet sind, und wobei dieser Abstand in Abhängigkeit von der vorgegebenen Mindestbreite gewählt ist.

3. Gehäuse (1) nach Anspruch 2, wobei die Schraube (4a) des zusätzlichen Bremselements ein sich über den gesamten Schraubenschaft erstreckendes, durchgängiges Gewinde aufweist.

4. Gehäuse (1) nach Anspruch 1, wobei die Fixierschrauben (4) und die Schrauben (4a) der zusätzlichen Bremselemente auf der dem Deckel (3) gegenüberliegenden Seite der Wanne (2) angeordnet sind, wobei insbesondere die Fixierschrauben (4) und die Schrauben (4a) der zusätzlichen Bremselemente jeweils in Gewinde (7) des Deckels (3) eingeschraubt sind.

5. Gehäuse (1) nach Anspruch 4, wobei die Fixierschrauben (4) und die Schrauben (4a) der zusätzlichen Bremselemente jeweils in einem Führungskanal der Wanne (2) angeordnet sind, wobei optional ein Querschnitt eines Führungskanals (10) im Bereich der Hülse (5) derart gewählt ist, dass die komprimierte Hülse (5) den Führungskanal (10) berührt.

6. Gehäuse (1) nach einem der vorhergehenden Ansprüche, wobei jede Fixierschraube (4) der Mehrzahl von Fixierschrauben (4) jeweils durch eine Hülse (5) mit Deformationsstrukturen (14.n) geführt ist.

7. Gehäuse (1) nach einem der vorhergehenden Ansprüche, wobei die Hülsen (5, 5a) der Öffnungselemente und der zusätzlichen Bremselemente derart vorgeformt sind, dass sie beim Aufstecken auf einen Schaft der Schraube/Fixierschraube (4, 4a) verliersicher gehalten sind.

8. Gehäuse (1) nach einem der vorhergehenden Ansprüche, wobei die Hülsen (5, 5a) als Einpresshülsen an der Wanne (2) vor dem Verschrauben ausgeführt sind.

9. Gehäuse (1) nach einem der vorhergehenden Ansprüche, wobei die Wanne (2) eine Formgebungsstruktur aufweist, auf die die Hülse (5, 5a) aufgesetzt ist, und die gestaltet ist, unter Einwirkung der Explosionskraft die Deformation der Hülse (5, 5a) zu bestimmen.

10. Gehäuse (1) nach einem der vorhergehenden Ansprüche, wobei die Deformationsstrukturen (14.n) zumindest teilweise als Schlitze ausgebildet sind.

11. Gehäuse (1) nach einem der vorhergehenden Ansprüche, wobei die Hülse (5, 5a) mindestens drei longitudinal verlaufende Schlitze aufweist und/oder die Deformationsstrukturen (14.n) durch Entfernen von Hülsenmaterial hergestellt oder als Prägestrukturen ausgeführt sind.

12. Gehäuse (1) nach einem der vorhergehenden Ansprüche, wobei die Deformationsstrukturen (14.n) zumindest teilweise als Löcher ausgebildet sind.

13. Gehäuse (1) nach einem der vorangehenden Ansprüche, wobei zur Fixierung und Sicherung des Deckels auf der Wanne in abwechselnder Reihenfolge entlang des Umfangs des Gehäuses Öffnungselemente, umfassend Fixierschrauben (4) und Hülsen (5), und Bremselemente, umfassend Schrauben (4a) und weitere Hülsen (5a) vorgesehen sind, wobei insbesondere das Gehäuse (1) eine rechteckige Grundform aufweist und die Öffnungselemente mittig an den Längsseiten und die zusätzlichen Bremselemente in den Eckbereichen angeordnet sind.

14. Gehäuse (1) nach einem der vorangehenden Ansprüche, wobei die Deformationsstruktur (14.n) der Hülse (5a) des zusätzlichen Bremselements in ihrem dem Schraubenkopf (4a) zugewandten Anfangsbereich nachgiebiger ausgestaltet ist als im restlichen Bereich der Hülse (5a).

15. Gehäuse (1) nach einem der vorangehenden Ansprüche, wobei mindestens eine der Mehrzahl von Fixierschrauben (4) und/oder die Schraube (4) ein Zentrierelement (25) aufweisen, um die Hülse (5) und/oder die weitere Hülse (5a) zentriert gegen den Schraubkopf zu pressen.

## Claims

1. A housing (1) for a power electronics device, comprising,
- a tray (2) for receiving power electronics components;
- a cover (3) for fitting on the tray (2) so that a closed housing (1) is formed,
wherein the cover (3) is fixed on the tray (2) through a plurality of fixing screws (4), wherein
at least one opening element is provided, wherein the opening element is formed through a fixing screw of the plurality of fixing screws (4), each of which is guided through an opening sleeve (5) with deformation structures (14.n), said sleeve being arranged between the screw head of the fixing screw (4) and the housing (1) such that a pressing force is exerted through the screw head of the fixing screw (4) between the cover (3) and the tray (2) via the opening sleeve (5),
wherein the deformation structures (14.n) are formed such that, under the effect of an explosion force exceeding the pressing force, the opening sleeve (5) is compressed in a manner defined through the deformation structures (14.n) such that a gap (11) of predefined width is formed between the cover (3) and tray (2),
**characterized in that**
at least one additional braking element is provided,
wherein the at least one additional braking element comprises a screw (4a) and a further sleeve (5a) with deformation structures (14.n), wherein the screw (4a) is guided through the further sleeve (5a),
wherein the further sleeve (5a) is arranged between the screw head of the screw (4a) and the housing (1) in such a way that the further sleeve (5a) is compressible in a manner defined through the deformation structures (14.n) only from a predefined minimum width of the gap (11).

2. The housing (1) according to claim 1, wherein the screw head (4a) and the sleeve (5a) of the additional braking element are arranged at a distance from one another, and wherein this distance is selected as a function of the predetermined minimum width.

3. The housing (1) according to claim 2, wherein the screw (4a) of the additional braking element has a continuous thread extending over the entire screw shaft.

4. The housing (1) according to claim 1, wherein the fixing screws (4) and the screws (4a) of the additional braking elements are arranged on the side of the trough (2) opposite the cover (3).

5. The housing according to claim 4, wherein the fixing screws (4) and the screws (4a) of the additional braking elements are each arranged in a guide channel of the trough (2), wherein optionally a cross-section the guide channel (10) in the region of the sleeve (5) is selected such that the compressed sleeve (5) touches the guide channel (10)

6. The housing (1) according to one of the preceding claims, wherein each (4) of the plurality of screw-fixing (4) is guided in each case by a sleeve (5) with deformation structures (14.n).

7. The housing (1) according to one of the preceding claims, wherein the sleeves (5, 5a) of the opening elements and the additional braking elements are preformed in such a way that they are held in a captive manner when they are fitted onto a shaft of the screw/fixing screw (4, 4a).

8. The housing (1) according to one of the preceding claims, wherein the sleeves (5, 5a) are designed as press-fit sleeves to the trough (2) before screwing.

9. The housing (1) according to one of the preceding claims, wherein the trough (2) has a moulding structure onto which the sleeve (5, 5a) is placed and which is designed to determine the deformation of the sleeve (5, 5a) under the application of the explosive force.

10. The housing (1) according to one of the preceding claims, wherein the deformation structures (14.n) are at least partially designed as slots.

11. The housing (1) according to one of the preceding claims, wherein the sleeve (5, 5a) has at least three longitudinally extending slots and/or the deformation structures (14.n) are produced by removing sleeve material or are designed as embossed structures.

12. The housing (1) according to one of the preceding claims, wherein the deformation structures (14.n) are at least partially designed as holes.

13. The housing (1) according to one of the preceding claims , wherein opening elements, comprising fixing screws (4) and sleeves (5), and braking elements, comprising screws (4a) and further sleeves (5a), are provided in alternating sequence along the circumference of the housing for fixing and securing the cover on the trough, wherein in particular the housing (1) has a rectangular basic shape and the opening elements are arranged centrally on the longitudinal sides and the additional braking elements are arranged in the corner regions.

14. The housing (1) according to one of the preceding claims, wherein the deformation structure (14.n) of the sleeve (5a) of the additional braking element in its initial region facing the screw head (4a) is designed to be more resilient than in the remaining region of the sleeve (5a)

15. The housing (1) according to one of the preceding claims, wherein at least one of the plurality of fixing screws (4) and/or the screw (4) have a centering element (25) in order to press the sleeve (5) and/or the additional sleeve (5a) centered against the screw head.

## Revendications

1. Boîtier (1) pour un appareil d'électronique de puissance, comprenant,
- une cuve (2) destinée à recevoir des composants électroniques de puissance;
- un couvercle (3) destiné à être placé sur la cuve (2), de manière à former un boîtier fermé (1)
le couvercle (3) étant fixé sur la cuve (2) par une pluralité de vis de fixation (4),
au moins un élément d'ouverture étant prévu, l'élément d'ouverture étant formé par une vis de fixation de la pluralité de vis de fixation (4), qui est guidée respectivement par une douille d'ouverture (5) avec des structures de déformation (14.n), qui est disposée entre la tête de vis de la vis de fixation (4) et le boîtier (1), de sorte qu'une force de pression entre le couvercle (3) et la cuve (2) est exercée par la tête de vis de la vis de fixation (4) via la douille d'ouverture (5),
les structures de déformation (14.n) étant conçues de telle sorte que, sous l'effet d'une force d'explosion dépassant la force de pression, la douille d'ouverture (5) est comprimée d'une manière définie par les structures de déformation (14.n) de telle sorte qu'une fente (11) de largeur prédéterminée est formée entre le couvercle (3) et la cuve (2),
**caractérisé en ce que**
au moins un élément de freinage supplémentaire est prévu,
l'au moins un élément de freinage supplémentaire comprenant une vis (4a) et une autre douille (5a) avec des structures de déformation (14.n), la vis (4a) étant guidée par l'autre douille (5a),
l'autre douille (5a) étant disposée entre la tête de vis de la vis (4a) et le boîtier (1) de telle sorte que l'autre douille (5a) ne peut être comprimée d'une manière définie par les structures de déformation (14.n) qu'à partir d'une largeur minimale prédéfinie de la fente (11).

2. Boîtier (1) selon la revendication 1, dans lequel la tête de vis (4a) et la douille (5a) de l'élément de freinage supplémentaire sont disposées à une certaine distance l'une de l'autre, et dans lequel cette distance est choisie en fonction de la largeur minimale prédéfinie.

3. Boîtier (1) selon la revendication 2, dans lequel la vis (4a) de l'élément de freinage supplémentaire présente un filetage continu s'étendant sur toute la tige de la vis.

4. Boîtier (1) selon la revendication 1, dans lequel les vis de fixation (4) et les vis (4a) des éléments de freinage supplémentaires sont disposées sur le côté de la cuve (2) opposé au couvercle (3), les vis de fixation (4) et les vis (4a) des éléments de freinage supplémentaires étant notamment vissées chacune dans des filets (7) du couvercle (3).

5. Boîtier (1) selon la revendication 4, les vis de fixation (4) et les vis (4a) des éléments de freinage supplémentaires étant respectivement disposées dans un canal de guidage de la cuve (2), une section transversale d'un canal de guidage (10) étant éventuellement choisie dans la zone de la douille (5) de telle sorte que la douille comprimée (5) touche le canal de guidage (10).

6. Boîtier (1) selon l'une des revendications précédentes, dans lequel chaque vis de fixation (4) de la pluralité de vis de fixation (4) est guidée respectivement par une douille (5) avec des structures de déformation (14.n).

7. Boîtier (1) selon l'une des revendications précédentes, dans lequel les douilles (5, 5a) des éléments d'ouverture et des éléments de freinage supplémentaires sont préformées de telle sorte qu'elles sont maintenues sans risque de perte lors de l'emboîtement sur une tige de la vis/vis de fixation (4, 4a).

8. Boîtier (1) selon l'une des revendications précédentes, dans lequel les douilles (5, 5a) sont réalisées sous forme de douilles à enfoncer sur la cuve (2) avant le vissage.

9. Boîtier (1) selon l'une des revendications précédentes, dans lequel la cuve (2) comporte une structure de moulage sur laquelle est rapporté le manchon (5, 5a) et qui est configurée pour déterminer la déformation du manchon (5, 5a) sous l'effet de la force explosive.

10. Boîtier (1) selon l'une des revendications précédentes, dans lequel les structures de déformation (14.n) sont au moins partiellement réalisées sous forme de fentes.

11. Boîtier (1) selon l'une des revendications précédentes, la douille (5, 5a) présentant au moins trois fentes s'étendant longitudinalement et/ou les structures de déformation (14.n) étant fabriquées par enlèvement de matériau de la douille ou étant réalisées sous forme de structures estampées.

12. Boîtier (1) selon l'une des revendications précédentes, dans lequel les structures de déformation (14.n) sont réalisées au moins partiellement sous forme de trous.

13. Boîtier (1) selon l'une des revendications précédentes, dans lequel, pour la fixation et le blocage du couvercle sur la cuve, il est prévu, en alternance le long de la périphérie du boîtier, des éléments d'ouverture, comprenant des vis de fixation (4) et des douilles (5), et des éléments de freinage, comprenant des vis (4a) et d'autres douilles (5a), le boîtier (1) présentant en particulier une forme de base rectangulaire et les éléments d'ouverture étant disposés au milieu sur les côtés longitudinaux et les éléments de freinage supplémentaires étant disposés dans les zones de coin.

14. Boîtier (1) selon l'une des revendications précédentes, dans lequel la structure de déformation (14.n) de la douille (5a) de l'élément de freinage supplémentaire est conçue de manière plus souple dans sa zone initiale tournée vers la tête de vis (4a) que dans la zone restante de la douille (5a).

15. Boîtier (1) selon l'une des revendications précédentes, dans lequel au moins une de la pluralité de vis de fixation (4) et/ou la vis (4) présente un élément de centrage (25) pour presser la douille (5) et/ou la douille supplémentaire (5a) de manière centrée contre la tête de vis.
